# EUROPEAN PATENT APPLICATION

(11) **EP 4 770 289 A1**
(43) Date of publication of application: **01.07.2026**
(21) Application number: 25203893.0
(22) Date of filing: 23.09.2025
(51) Int. Cl.: H05K 7/14, H02M 7/00, H05K 7/20

(54) **INVERTER AND ENERGY STORAGE SYSTEM INCLUDING THE SAME**

(30) Priority: 24.12.2024 KR 20240196177
(71) Applicant: Hanwha Solutions Corporation, Jung-gu Seoul 04541 (KR)
(72) Inventor: PARK, Je Hyun, 04541 Seoul (KR); CHOI, You Chang, 04541 Seoul (KR)
(74) Representative: Mooser, Sebastian Thomas

(57) **Abstract**

Provided is an inverter including a main case, a heat dissipation case that covers one side of the main case and has a plurality of heat dissipation fins, a main plate arranged in an internal space defined by an assembly of the main case and the heat dissipation case, and a circuit board unit configured to mutually convert between direct current power and alternating current power and having a plurality of circuit boards, wherein some of the plurality of circuit boards are arranged below the main plate, and others of the plurality of circuit boards are arranged on the main plate.

## Description

### BACKGROUND

### 1. Field

The present disclosure relates to an inverter and an energy storage system including the same.

### 2. Description of the Related Art

In general, an inverter is a device that converts direct current (DC) electricity generated by an electrical energy generation device, such as a solar module, into alternating current (AC) electricity, and stores electrical energy in a battery serving as a power storage device, and may also supply AC electricity to home appliances that consume AC electricity, and a power grid, and maintain power quality by adjusting an output voltage and frequency.

An inverter may be used as a standalone unit connected to a solar panel, a power grid, and the like, but may also be integrated with other external devices, such as an energy storage system (ESS), to serve as an all-in-one solution. This configuration may improve the efficiency of power conversion and storage.

### SUMMARY

The present disclosure provides an inverter having improved space efficiency, and an energy storage system including the inverter.

Additional aspects will be set forth in part in the description which follows and, in part, will be apparent from the description, or may be learned by practice of the presented embodiments of the disclosure.

An embodiment of the present disclosure provides an inverter including: a main case; a heat dissipation case that covers one side of the main case and has a plurality of heat dissipation fins; a main plate arranged in an internal space defined by an assembly of the main case and the heat dissipation case; and a circuit board unit configured to mutually convert between direct current power and alternating current power and having a plurality of circuit boards, wherein some of the plurality of circuit boards are arranged below the main plate, and others of the plurality of circuit boards are arranged on the main plate.

In an embodiment, the heat dissipation case may include: a first body connected to the main case, wherein the plurality of circuit boards are arranged in a first space inside the first body, and the plurality of heat dissipation fins are arranged outside the first body; and a second body arranged adjacent to the plurality of heat dissipation fins and having a second space recessed downward from the first body.

In an embodiment, the inverter may further include a sub-plate that covers an upper portion of the second body.

In an embodiment, the sub-plate may include a cover portion that covers an open area of the second body, and a connection end extending from the cover portion and supported by the first body.

In an embodiment, the first space and the second space may communicate with each other through a through-hole defined between the cover portion and the connection end.

In an embodiment, the circuit board unit may include: a first board arranged in the first body; a second board supported by a sub-plate arranged on the second body; and a third board arranged inside the second body.

In an embodiment, the first board may generate a greater amount of heat than the second board and the third board.

In an embodiment, the first board and the second board may be arranged in a space below the main plate.

In an embodiment, a fourth board that overlaps with the first board and the second board may be arranged on the main plate.

In an embodiment, the main plate may include a connection hole that communicates with an internal space of the heat dissipation case.

In addition, another embodiment of the present disclosure provides an energy storage system including: a storage device; and an inverter installed on the storage device, wherein the inverter includes: a main case; a heat dissipation case that covers one side of the main case and has a plurality of heat dissipation fins; a main plate arranged in an internal space defined by an assembly of the main case and the heat dissipation case; and a circuit board unit configured to mutually convert between direct current power and alternating current power and having a plurality of circuit boards, wherein some of the plurality of circuit boards are arranged below the main plate, and others of the plurality of circuit boards are arranged on the main plate.

In an embodiment, the heat dissipation case may include: a first body connected to the main case, wherein the plurality of circuit boards are arranged in a first space inside the first body, and the plurality of heat dissipation fins are arranged outside the first body; and a second body arranged adjacent to the plurality of heat dissipation fins and having a second space recessed downward from the first body.

In an embodiment, the energy storage system may further include a sub-plate that covers an upper portion of the second body.

In an embodiment, the circuit board unit may include: a first board arranged in the first body; a second board supported by a sub-plate arranged on the second body; and a third board arranged inside the second body.

In an embodiment, the main plate may include a connection hole that communicates with an internal space of the heat dissipation case.

Other aspects, features, advantages other than those described above will become apparent from the following drawings, claims, and detailed description of the present disclosure.

### BRIEF DESCRIPTION OF THE DRAWINGS

The above and other aspects, features, and advantages of certain embodiments of the disclosure will be more apparent from the following description taken in conjunction with the accompanying drawings in which:
FIG. 1 is a block diagram schematically illustrating an energy storage and distribution system according to an embodiment of the present disclosure;
FIG. 2 is a block diagram schematically illustrating an energy storage system and a controller, according to an embodiment of the present disclosure;
FIG. 3 is a diagram illustrating coupling between an inverter and a storage device, according to an embodiment of the present disclosure;
FIG. 4 is an exploded perspective view of the inverter of FIG. 3;
FIG. 5 is an exploded perspective view of some components of FIG. 4;
FIG. 6 is a diagram illustrating an inverter with its door in an open state, according to an embodiment of the present disclosure;
FIG. 7 is a cross-sectional view taken along line I-I' of FIG. 6;
FIG. 8 is a perspective cross-sectional view taken along line II-II' of FIG. 6; and
FIG. 9 is a cross-sectional view taken along line II-II' of FIG. 6.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects.

As the present disclosure allows for various changes and numerous embodiments, particular embodiments will be illustrated in the drawings and described in detail. Advantages and features of the present disclosure and a method of achieving the same should become clear with embodiments described below in detail with reference to the drawings. However, the present disclosure is not limited to the embodiments disclosed below, but may be implemented in various forms.

Hereinafter, embodiments of the present disclosure will be described in detail with reference to the accompanying drawings, and the same or corresponding components will be denoted by the same reference numerals when described with reference to the accompanying drawings, and thus, their descriptions that are already provided will be omitted.

In the following embodiments, terms such as "first," "second," etc., are used only to distinguish one component from another, and such components must not be limited by these terms.

In the following embodiments, the singular expression also includes the plural meaning as long as it is not inconsistent with the context.

In the following embodiments, the terms "comprise," "include," "have," and the like used herein specify the presence of stated features or components, but do not preclude the presence or addition of one or more other features or components.

In the following embodiments, when an element such as a layer, region, or component is referred to as being "on," "in front of," "behind," or "under" another element, it may encompass cases where the elements are in direct contact, as well as cases where intervening elements may be present.

For convenience of descriptions, the magnitude of components in the drawings may be exaggerated or reduced. For example, the size and thickness of each element illustrated in the drawings are provided arbitrarily for convenience of descriptions, and thus, the present disclosure is not necessarily limited to those illustrated in the drawings.

In addition, it should be understood that some elements may be omitted, only a part of an element may be illustrated, or an element may be schematically represented in the drawings for the purpose of simplification, or when deemed sufficient or necessary for the description.

In the following embodiments, when an element is referred to as being "connected" to another element, this may include both cases where they are directly connected and cases where they are indirectly connected with other elements therebetween.

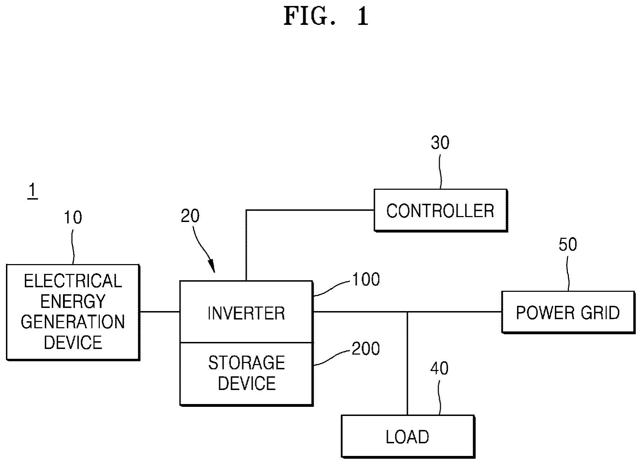

FIG. 1 is a block diagram schematically illustrating an energy storage and distribution system according to an embodiment of the present disclosure.

Referring to FIG. 1, an energy storage and distribution system 1 may convert direct current (DC) electricity generated from an electrical energy generation device 10 such as a solar module, into alternating current (AC) electricity, and supply the AC electricity to a load 40, a power grid 50, and the like, or may store power generated from the electrical energy generation device 10 in a storage device 200, and then convert and supply the stored power as needed.

The electrical energy generation device 10 refers to a device that generates electrical energy by converting various forms of energy, and may generate electrical energy in various ways depending on the type of energy source.

For example, the electrical energy generation device 10 may be a solar module that converts sunlight into electrical energy by using a solar panel. However, the present disclosure is not limited thereto, and the electrical energy generation device 10 may be provided as various devices, such as a wind power generation device or a hydroelectric power generation device.

An energy storage system 20 stores electricity generated from the electrical energy generation device 10, such as a solar module, and converts the stored DC electricity into AC electricity to supply the AC electricity to an external destination, and may include an inverter 100 and the storage device 200.

The inverter 100 may be connected to or integrated with the storage device 200. Accordingly, DC electricity generated from the electrical energy generation device 10 may be stored in the storage device 200 and then converted into AC electricity by the inverter 100 to be supplied to the load 40, the power grid 50, and the like, as needed.

However, the present disclosure is not limited thereto, and within the technical scope of being able to mutually convert between DC electricity and AC electricity from an external source, the inverter 100 may be connected to or integrated with various components of the energy storage system, such as a converter, a battery management system (BMS), or a power management system.

A controller 30 is electrically connected to the energy storage system 20, and may receive operation data from the energy storage system 20 to monitor its operational status and control its operating conditions.

In some embodiments, the controller 30 may check the operational status of the inverter 100 in real time. In some embodiments, the controller 30 may receive, from the inverter 100, information about various parameters of the electrical energy generation device 10, such as the total amount of power generation or the AC voltage. In some embodiments, when a defect or failure occurs during the operation of the inverter 100, the controller 30 may generate an alarm to notify a user.

The load 40 is a general term referring to any device that consumes electricity, and examples of the load 40 may include household electrical appliances, heating and cooling systems, lighting and equipment in commercial facilities, and machinery in industrial sites. In general, because the load 40 uses AC electricity, DC electricity introduced to charge the storage device 200 is converted into AC electricity by the inverter 100 and then supplied to the load 40.

The power grid 50 may be defined as a power network that transmits and distributes AC electricity, which has been converted by the inverter 100, to supply the AC electricity to consumers. The power grid 50 may be connected to an electrical distribution network of a house or building to distribute electrical energy supplied from the electrical energy generation device 10 or the energy storage system 20.

In other words, the energy storage and distribution system 1 according to an embodiment of the present disclosure may be a power network where electrical energy generated from the electrical energy generation device 10 enters the energy storage system 20 to be stored in the storage device 200, or the stored electrical energy is converted and supplied to the load 40 and the power grid 50 to be ultimately delivered to consumers.

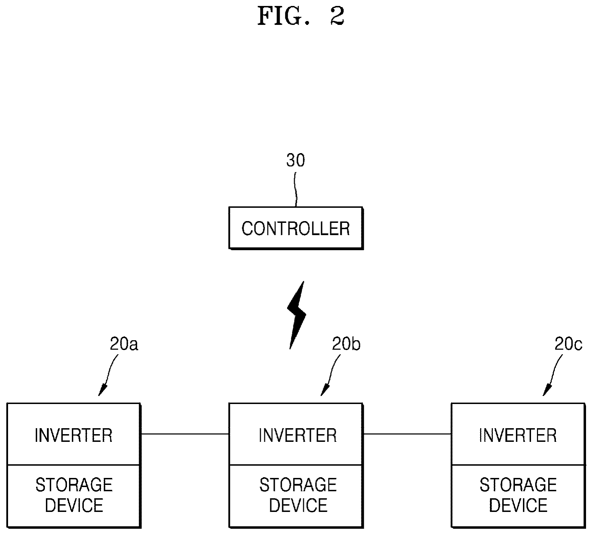

FIG. 2 is a block diagram schematically illustrating an energy storage system and a controller, according to an embodiment of the present disclosure.

Referring to FIG. 2, a plurality of energy storage systems 20 may be provided and connected to each other. The number of energy storage systems 20 is not limited to a specific number and may be variously configured depending on the installation location of the energy storage systems 20, or the like. However, for convenience of descriptions, the following description will focus on an embodiment in which three energy storage systems 20a, 20b, and 20c are connected to the controller 30.

In an embodiment, the energy storage systems may include a first energy storage system 20a, a second energy storage system 20b, and a third energy storage system 20c, which may be electrically connected to each other. For example, the first energy storage system 20a, the second energy storage system 20b, and the third energy storage system 20c may be connected to each other by cables to transmit electrical signals or to allow current to flow between them.

The controller 30 according to an embodiment of the present disclosure may be connected to the first energy storage system 20a, the second energy storage system 20b, and the third energy storage system 20c via wired or wireless communication.

In a case in which the controller 30 is connected by wire to the first energy storage system 20a, the second energy storage system 20b, and the third energy storage system 20c, the controller 30 may be connected to a storage device of any one of the first energy storage system 20a, the second energy storage system 20b, and the third energy storage system 20c, and may receive operation data from the other storage devices.

In another embodiment, the controller 30 may be connected to each of the first energy storage system 20a, the second energy storage system 20b, and the third energy storage system 20c to receive their respective operation data.

In some embodiments, the controller 30 may be wirelessly connected to the energy storage system 20 to receive operation data via wireless communication.

As the controller 30 monitors information about the energy storage system 20 and the inverter 100 in real time and adjust operating conditions, it is possible to immediately respond to a problem occurring during the operation of the inverter 100, and a power consumption or the like is output in real time such that processes of generating, storing, and distributing electrical energy are performed more efficiently.

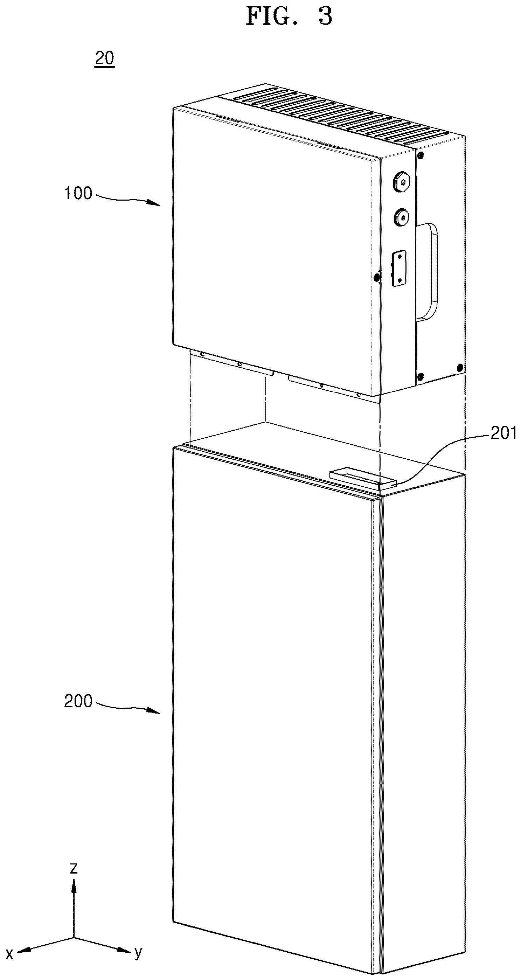

FIG. 3 is a diagram illustrating coupling between an inverter and a storage device, according to an embodiment of the present disclosure.

The energy storage system 20 according to an embodiment of the present disclosure may include the inverter 100 and the storage device 200.

The inverter 100 and the storage device 200 may be electrically connected to each other via a DC connector or AC connector (not shown), and accordingly, the inverter 100 may receive DC electricity or convert the received DC electricity into AC electricity to transmit the AC electricity to an external destination.

The inverter 100 may be coupled to the storage device 200 in a vertical direction. In the present specification, the term "vertical direction" may refer to a z-axis direction, an up-down direction in FIG. 3, and a lengthwise direction of the storage device.

In some embodiments, the inverter 100 may be connected to a connection protrusion 201 of the storage device 200. The connection protrusion 201 may be formed in the shape of a partition wall surrounding a predetermined area of the storage device 200, which faces the inverter 100.

Here, a connection cable, a wire, a connector, or the like, which electrically connects the inverter 100 to the storage device 200, may pass through a surface of the storage device 200 that is enclosed by the connection protrusion 201 to be connected to a connection terminal inside the inverter 100.

The storage device 200 may be a power storage device for storing electrical energy supplied from an external electrical energy generation device 10.

Thus, although the present specification describes an example in which the storage device 200 is a power storage device, the present disclosure is not limited thereto, and various modifications may be made to other external devices within the technical scope where the inverter 100 capable of mutually converting between DC and AC power may be installed.

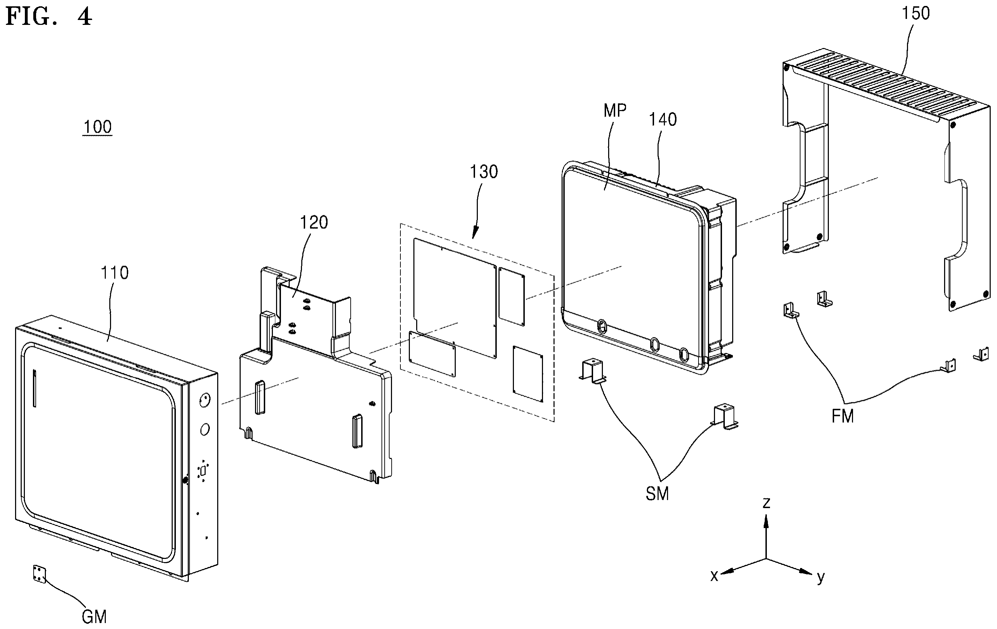

FIG. 4 is an exploded perspective view of the inverter of FIG. 3.

Referring to FIG. 4, the inverter 100 is capable of mutually converting between DC electricity and AC electricity supplied from an external source, and may include a main case 110, a safety cover 120, a circuit board unit 130, a heat dissipation case 140, and a hood cover 150.

The main case 110, the safety cover 120, the circuit board unit 130, and the heat dissipation case 140 may be coupled to each other in a first direction. In the present specification, the term "first direction" may refer to an x-axis direction, and the term "second direction" may refer to a y-axis direction.

The main case 110 may be connected to the storage device 200 through a fixing member GM. The heat dissipation case 140, which covers one side of the main case 110 and has a plurality of heat dissipation fins, defines an internal space in which the circuit board unit 130 may be arranged.

In the present specification, the term "internal space" may refer to a space that is defined by the assembly of the main case 110 and the heat dissipation case 140. In other words, the internal space may refer to a space enclosed by the main case 110 and the heat dissipation case 140.

In some embodiments, the safety cover 120 that covers the circuit board unit 130 may be arranged in the internal space. The safety cover 120 is arranged on one side of the circuit board unit 130 and protects a plurality of circuit boards from an external environment, and may prevent the circuit boards from being exposed to the external environment during the installation of the inverter 100, and may reduce the likelihood of failure and malfunction of the inverter 100.

In some embodiments, the safety cover 120 may physically separate components through which current flows, from a worker, thereby preventing electric shock accidents and enhancing the safety of the working environment.

The circuit board unit 130 may be arranged in the internal space and may have at least one circuit board capable of mutually converting between DC power and AC power.

In an embodiment, the circuit board unit 130 may have a plurality of circuit boards. The plurality of circuit boards may include a first board, a second board, a third board, and a fourth board, distinguished by their arrangement positions inside the inverter 100. Here, the circuit boards may be referred to as "circuit boards" or "a plurality of circuit boards".

Each circuit board may be provided as a filter board, a main board, a battery management and protection system (BMPS) board, a switching-mode power supply (SMPS) board, or the like, and may include power semiconductors such as metal-oxide-semiconductor field-effect transistors (MOSFETs) or insulated-gate bipolar transistors (IGBTs), control circuits, sensors, a printed circuit boards, and the like. Here, the respective circuit boards may be stacked and arranged within the internal space, or may be arranged to be spaced apart from each other on the same plane.

A main plate MP may be arranged in the internal space, which is defined by the assembly of the main case 110 and the heat dissipation case 140. In some embodiments, the main plate MP may be arranged between the safety cover 120 and the heat dissipation case 140.

The main plate MP, which supports at least one circuit board of the circuit board unit 130, may partition the internal space.

Some of the plurality of circuit boards included in the circuit board unit 130 may be arranged below the main plate MP, while others may be arranged on the main plate MP.

The circuit board unit 130 may be arranged on opposite sides of the main plate MP. In other words, the plurality of circuit boards may be arranged in the multiple spaces that are partitioned by the main plate MP.

Although not shown in the drawings, the plurality of circuit boards may be arranged not only in the space between the safety cover 120 and the main plate MP but also in the space between the main plate MP and the heat dissipation case 140.

Accordingly, the plurality of circuit boards included in the circuit board unit 130 may be stacked and arranged in the first direction within the internal space of the inverter 100.

The safety cover 120 may be fastened and fixed to the main plate MP. In other words, the safety cover 120 may be fixed in place on the main plate MP while covering a portion of the circuit board unit.

The main plate MP may be pre-assembled with a plurality of coupling members (not shown), which support the safety cover 120 and connect the main plate MP to the safety cover 120.

In an embodiment, the coupling member may be provided as a supporter that may fix the safety cover 120 in position on the main plate MP and evenly distribute the load of the safety cover 120 to provide a stable support structure. In an embodiment, the coupling member may be provided as a standoff that is designed to maintain a preset interval between the safety cover 120 and the main plate MP.

The heat dissipation case 140 may be formed to protrude in the first direction. As the heat dissipation case 140 is formed to protrude outward, an inner side of the protruding area is concavely formed, thereby providing an internal space.

At least one circuit board may be accommodated in the space enclosed by the heat dissipation case 140 and the main plate MP. Accordingly, the plurality of circuit boards included in the circuit board unit 130 may be completely enclosed by the main case 110, the safety cover 120, and the heat dissipation case 140.

The heat dissipation case 140 has a plurality of heat dissipation fins and may efficiently dissipate heat generated from the circuit board unit 130 to the outside. Accordingly, the heat dissipation case 140 may prevent excessive heat from accumulating inside the inverter 100 to cause performance degradation of the circuit boards or defects during operation.

The hood cover 150 surrounds the heat dissipation case 140 and connects to the main case 110, and may be arranged to cover the side and upper surfaces of the heat dissipation case 140, thereby protecting the heat dissipation case 140 from the outside.

In some embodiments, the hood cover 150 may physically block a user or worker from contacting the surface of the heat dissipation case 140, which reaches a high temperature due to heat generated from the internal circuit boards, thereby protecting the user and worker.

A lower portion of the hood cover 150 may be connected to the upper surface of the storage device 200. In some embodiments, areas corresponding to the corners of the lower portion of the hood cover 150 may be fastened to the storage device 200 by fastening members FM, respectively. Accordingly, the inverter 100 may be securely fixed on the storage device 200.

The fastening member FM is fastened to the hood cover 150 and may connect the hood cover 150 to the storage device 200.

A plurality of fastening members FM may be provided. Some of the plurality of fastening members FM may be fixed by welding to a rear surface part of a main body 111, to fix the four corners of the hood cover 150 to the main case 110, and more specifically, to the main body 111.

In some embodiments, others of the plurality of fastening members FM may be fixed by welding onto the storage device 200, to fix opposite lower end portions (the lower side in FIG. 4) of the hood cover 150 to the storage device 200.

Because the main case 110 is connected to the hood cover 150 by the fastening members FM, and the hood cover 150 is connected to the storage device 200, the main case 110 may be indirectly fixed to the storage device 200.

The inverter 100 may further include the fixing member GM and support members SM.

The fixing member GM, which connects the main case 110 to the storage device 200, may be formed to extend in a vertical direction, such that one side thereof may be connected to the main case 110, and the other side thereof may be connected to the storage device 200.

Accordingly, when the inverter 100 is installed on the storage device 200, the inverter 100 and the storage device 200 may be aligned with a common central axis in the vertical direction.

The support member SM is arranged between the heat dissipation case 140 and the storage device 200, and one surface of the support member SM may contact the storage device 200, and the opposite surface may contact the heat dissipation case 140.

Accordingly, the support members SM may stably support a lower portion of the heat dissipation case 140 that protrudes in the first direction, and may space the heat dissipation case 140 apart from the storage device 200 by a preset interval.

A plurality of support members SM may be provided, and the plurality of support members SM may be respectively arranged on opposite sides of the heat dissipation case 140 to distribute the weight of the heat dissipation case 140 and thereby provide more stable support.

The upper surface (the upper side in FIG. 4) of the support member SM may undergo a masking treatment to serve as a ground connection between the heat dissipation case 140 and the storage device 200. Accordingly, the support members SM may physically support the inverter 100 and simultaneously improve the electrical stability of the entire energy storage system 20.

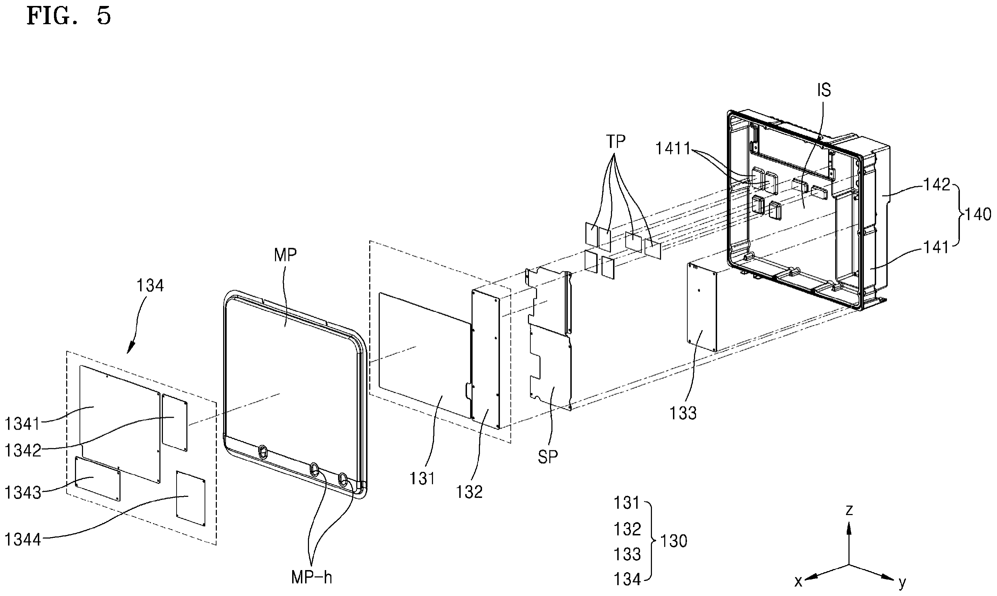

FIG. 5 is an exploded perspective view of some components of FIG. 4.

Referring to FIG. 5, the main plate MP, a sub-plate SP, and the circuit board unit 130 may be arranged in an internal space between the main case 110 and the heat dissipation case 140.

The main plate MP, which is arranged in the internal space and supports circuit boards, may be arranged to cover an open area of the heat dissipation case 140.

The main plate MP may have a shape that corresponds to a surface of the heat dissipation case 140. The main plate MP may separate the internal space into an internal space of the main case and an internal space of the heat dissipation case 140.

The circuit board unit 130, which is arranged in the internal space and has a plurality of circuit boards, may include a first board 131, a second board 132, a third board 133, and a fourth board 134. The plurality of circuit boards may be arranged in the internal space.

Among the plurality of circuit boards, the first board 131, the second board 132, and the third board 133 may be arranged below the main plate MP (the right side in FIG. 5), while the fourth board 134 may be arranged on the main plate MP. The first board 131, the second board 132, and the third board 133, which are arranged below the main plate MP, may also be referred to as the circuit boards arranged in the heat dissipation case 140.

The first board 131 may be a main board of the inverter 100, capable of mutually converting between DC power and AC power.

The second board 132 may be a filter board that improves device performance by selectively passing signals in a specific frequency band or by removing noise included in an electrical signal.

The third board 133 may be an SMPS board that converts power input from an external source to distribute a DC voltage to other circuit boards.

The fourth board 134 may include circuit boards connected to the storage device 200, for example, a BMPS board, an EMS board, a relay board, and the like.

The arrangement of the first board 131, the second board 132, the third board 133, and the fourth board 134, which constitute the circuit board unit 130, will be described in detail below.

The main plate MP may include aluminum. Accordingly, electromagnetic waves generated from the circuit boards are reflected by the main plate MP and are thus prevented from passing through the main plate MP. In other words, the main plate MP may serve to physically shield electromagnetic waves, thereby preventing electromagnetic waves generated from the circuit boards arranged in the heat dissipation case 140 from passing through the main plate MP and being emitted to the outside.

However, the material of the main plate MP is not limited thereto, and various modifications are possible within the technical scope, provided that the main plate MP is formed of a metallic material capable of blocking the propagation of electromagnetic waves, such as aluminum, copper, or stainless steel.

The main plate MP may have connection holes MP-h that communicate with the internal space of the heat dissipation case 140.

The connection hole MP-h may be a passage for a cable that connects a circuit board arranged on the main plate MP to a circuit board arranged in the heat dissipation case 140.

A plurality of connection holes MP-h may be provided and arranged to be spaced apart from each other in the main plate MP. In an embodiment, the plurality of connection holes MP-h may be arranged on the main plate MP in a second direction.

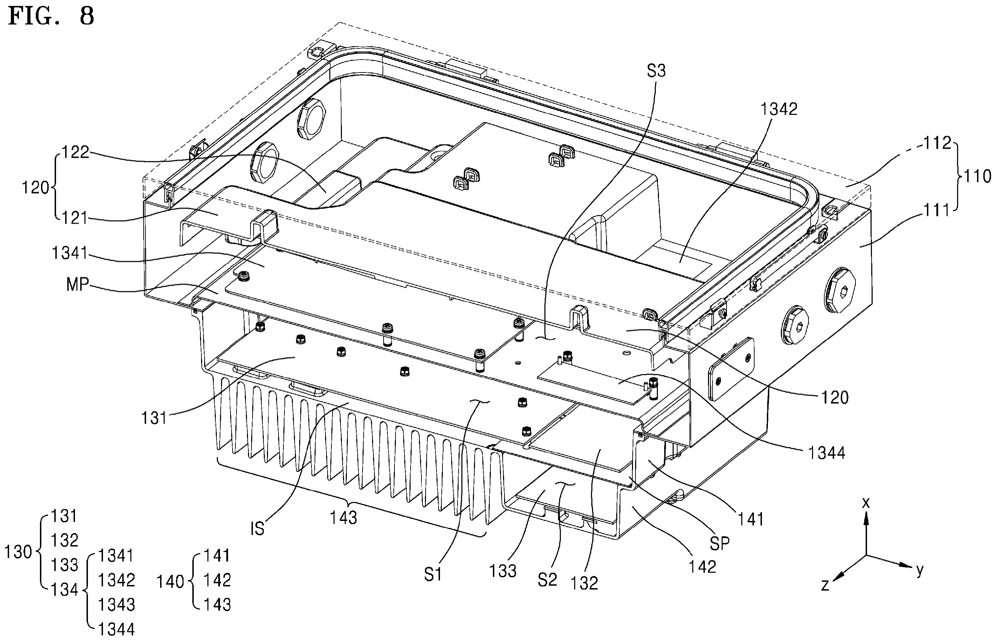

Referring to FIG. 8, the heat dissipation case 140 may include a first body 141, a second body 142, and heat dissipation fins 143.

The first body 141 may be connected to the main case 110, a circuit board may be arranged in a first space S1 formed inside the first body 141, the heat dissipation fins 143 may be arranged outside the first body 141, and the first body 141 may form the outer shape of the heat dissipation case 140.

The second body 142 may be arranged adjacent to the heat dissipation fins 143 and may have a second space S2, which is recessed downward (the right side in FIG. 5) from the first body 141, a circuit board may be arranged in the second space S2.

In other words, the second body 142 may be formed to protrude from the first body 141 and thus have the second space S2 therein. The second body 142 and the heat dissipation fins 143 may be arranged on a rear surface (the left side in FIG. 5) of the first body 141.

A plurality of heat dissipation fins 143 may be provided and arranged on a surface of the heat dissipation case 140 to protrude outward.

The heat dissipation fins 143 may extend in a vertical direction, may each have a long and thin shape, and may be arranged on the heat dissipation case 140 to be spaced apart from each other by a preset interval. Due to such an optimized structure of the heat dissipation fins 143, the surface area of the heat dissipation case 140 may be maximized, and the heat dissipation efficiency may be increased.

The heat dissipation fins 143 may include various materials, for example, a metallic material with high thermal conductivity, such as aluminum or copper. However, the present disclosure is not limited thereto, and various modifications to the material are possible within the technical scope, provided that the material has high thermal conductivity and is capable of efficiently dissipating heat from the inside of the heat dissipation case 140.

The sub-plate SP, which is arranged inside the heat dissipation case 140, may cover an upper portion of the second body 142. The sub-plate SP may separate the space inside the heat dissipation case 140.

In other words, the main plate MP and the sub-plate SP may separate the internal space, which is enclosed by the main case 110 and the heat dissipation case 140, into a total of three spaces.

In the present specification, for convenience of descriptions, in the internal space, the space within the heat dissipation case 140 that is enclosed by the main plate MP and the first body 141 is defined as the first space S1, and the space enclosed by the sub-plate SP and the second body 142 is defined as the second space S2. Furthermore, the space enclosed by the main case 110 and the main plate MP is defined as a third space S3.

Here, the first space S1 may be the internal space of the first body 141, and the second space S2 may be the internal space of the second body 142.

The heat dissipation case 140 may have support blocks 1411 that protrude toward the internal space, and on which a circuit board is arranged.

In the present specification, a surface of the heat dissipation case 140 on which the support blocks 1411 are arranged is defined as an inner surface IS.

The support blocks 1411 may protrude from the inner surface IS, and a plurality of support blocks 1411 may be arranged on the heat dissipation case 140. Here, the circuit board unit 130 may be supported by the plurality of support blocks 1411, and may be arranged to be spaced apart from the inner surface IS by a preset interval.

Thermally conductive pads TP, which are arranged between the support block 1411 and a circuit board, may directly transfer heat generated from the circuit board to the heat dissipation case 140.

The thermally conductive pads TP according to an embodiment of the present disclosure may be arranged on the plurality of support blocks 1411, respectively.

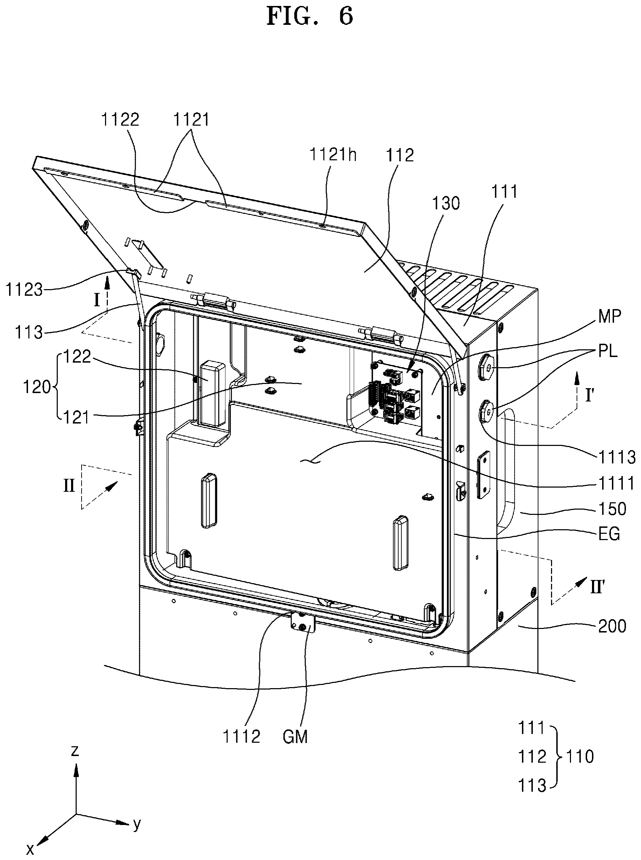

FIG. 6 is a diagram illustrating an inverter with its door in an open state, according to an embodiment of the present disclosure.

Referring to FIG. 6, the main case 110 may include a main body 111, a door 112, and safety rods 113.

The main case 110 has an internal space defined by its assembly with the heat dissipation case 140 and is installed on the storage device 200, and the safety cover 120 and the circuit board unit 130 may be arranged in the internal space of the main case 110.

The main body 111 may have an internal space therein and an opening 1111 on one of its surfaces. Here, the opening 1111 may be covered by the door 112.

The door 112 is rotatably connected to the main body 111 and is capable of covering the opening 1111, and the area of the door 112 may correspond to the surface of the main body 111 on which the opening 1111 is formed.

Accordingly, a worker, as needed, may rotate the door 112 up and down to open and close the opening 1111, or attach or detach the door 112 to or from the main body 111, to perform tasks necessary for installing and replacing the inverter 100.

In the present specification, the term "open state" of the door 112 (the state illustrated in FIG. 6) refers to a state in which the door 112 does not cover the opening 1111, is supported by the safety rods 113, and is arranged at a preset angle with respect to the main body 111, and the term "closed state" of the door 112 (the state illustrated in FIG. 3) refers to a state in which the door 112 covers the opening 1111.

The safety rods 113, which are arranged between the main body 111 and the door 112, may support the door 112 to allow the door 112 to maintain an open state.

One side of the safety rod 113 may be rotatably connected to the main body 111. In some embodiments, a slot-shaped rod hole (not shown) may be formed on one side of the safety rod 113. Here, the safety rod 113 may be constrained by a separate pin to a fixing bracket (not shown) that is arranged on a surface of the main body 111.

The rod hole extends in the lengthwise direction of the safety rod 113, and the safety rod 113 may perform not only rotational movement but also sliding movement in a vertical direction with respect to the main case 110.

Thus, when the safety rod 113 is hung on a rod support part 1123 and the door 112 forms a preset angle with respect to the main case 110, the safety rod 113 may slide down in the direction of gravity to be fixed in place.

Accordingly, when the door 112 moves partially due to an external force, such as a worker hitting it with their head or wind lifting it, the risk of the door 112 falling and injuring the worker may be physically prevented, and the safety of the working environment may be ensured.

One side of the safety rod 113 may be rotatably connected to the main body 111. Another side of the safety rod 113, which is not connected to the main body 111, may move freely to support the door 112 as the door 112 opens or closes, or may be located on a surface of the main body 111.

A shielding member EG may be arranged along the circumference of the opening 1111 of the main body 111. The shielding member EG may block electromagnetic waves that are generated by current flowing through the circuit board unit 130 arranged in the internal space of the main body 111, thereby preventing the electromagnetic waves from being emitted to the outside.

The shielding member EG may include various materials. For example, the shielding member EG may include aluminum, steel, polycarbonate, acrylonitrile butadiene styrene (ABS), silicone, rubber, or the like, and may be arranged along the circumference of the opening 1111, and various modifications to the material are possible within the technical scope, provided that the material is capable of blocking electromagnetic waves emitted from the circuit board unit 130.

A guide protrusion 1112 may be formed to protrude from a surface of the main case 110. In some embodiments, the guide protrusion 1112 may be arranged on a lower side (the lower side in FIG. 6) of the main case 110 that is adjacent to the storage device 200.

The guide protrusion 1112, which protrudes in the first direction, may be arranged on the surface of the main body 111 on which the opening 1111 is formed. The guide protrusion 1112 may be connected to the fixing member GM to align the inverter 100 and the storage device 200 in a line.

A cable hole 1113, through which a cable for connecting the inverter 100 to an external device may pass, may be formed on a surface of the main body 111. Here, the cable passing through the cable hole 1113 may be any of various types of cables, such as a power cable or a communication cable.

A plurality of cable holes 1113 may be arranged in a vertical direction on a surface of the main body 111. Accordingly, a plurality of cables connected to the inverter 100 may simultaneously pass through the main body 111 to connect to the internal circuit board unit 130 or to supply power.

In some embodiments, the cable holes 1113 may be arranged on opposite sides of the main body 111, respectively. Accordingly, a cable may selectively enter the left or right side of the inverter 100 to be easily connected to the circuit board unit 130.

A plug PL is coupled to the cable hole 1113 to seal the cable hole 1113 from the outside, and may be formed to have an outer diameter greater than an inner diameter of the cable hole 1113.

By using the plug PL, a gap between the cable and the cable hole 1113 may be completely filled, and external contaminants, moisture, and the like may be prevented from entering the interior space.

When a cable connection is needed, the plug PL may be removed. A separate connector may be inserted into the cable hole 1113 from which the plug PL has been removed. For example, the connector may be a conduit connector.

The connector, with a cable mounted therein, may be inserted into the cable hole 1113 to seal the cable hole 1113. Accordingly, damage to the cable may be prevented, and dust, moisture, and other external contaminants may be prevented from entering the internal space. In some embodiments, a cable that has passed through the cable hole 1113 while mounted on the connector may be stably fixed in position and connected to the circuit board.

Referring to FIG. 6, the door 112, which is rotatably connected to the main body 111 and is capable of covering the opening 1111, may prevent the circuit board unit 130 inside the main body 111 from being exposed to the outside.

In some embodiments, the door 112 may be hinge-connected to the main body 111 to be rotatable within a preset radius range. Accordingly, when installation of the inverter 100 is required, the door 112 may be rotated open to expose internal terminals and the like, and after the installation is complete, the door 112 may be rotated again to switch to a closed state such that the interior is not exposed.

However, the present disclosure is not limited thereto, and during the installation of the inverter 100, a worker may remove the door 112 to perform a necessary task, and reattach the door 112 after the task is completed.

The door 112 may include extension tabs 1121 that are connected to the storage device 200. The extension tab 1121 is a region that extends toward the storage device 200 in a state in which the door 112 is closed, and may contact a surface of the storage device 200. In some embodiments, the extension tab 1121 may be arranged in the second direction at an end portion of the door 112.

The extension tab 1121 may contact a surface of the storage device 200 in a state in which the door 112 covers the opening 1111, i.e., in a state in which the door 112 is closed, and here, the position of a fixing hole 1121h may correspond to the position of a hole formed in the storage device 200. In this state, the door 112 and the storage device 200 may be fastened together by using fastening elements such as nuts or screws.

The rod support part 1123 may be further formed on a surface of the door 112 that faces the main body 111. The rod support part 1123, which is formed to protrude in the first direction with reference to the closed state of the door 112, may support the safety rod 113 when the door 112 is open.

In some embodiments, the rod support part 1123 may be formed to protrude in a shape that encloses one end portion of the safety rod 113 that contacts the door 112. A hollow portion, in which the safety rod 113 is seated, may be formed on the surface of the rod support part 1123 that contacts the door 112.

When the door 112 opens at a preset angle with respect to the main body 111, one end portion of the safety rod 113, which was fixed to a surface of the main body 111, may be lifted up and fit into the hollow portion of the rod support part 1123, and accordingly, the safety rod 113 may stably fix and support the door 112.

The door 112 may be supported by the safety rod 113 through contact, and thus prevented from being closed.

In a case in which the safety rods 113 are arranged on opposite sides of the main body 111, respectively, the rod support parts 1123 may also be arranged on opposite sides of the door 112, respectively. Accordingly, a plurality of safety rods 113 may contact a plurality of rod support parts 1123, and the door 112 may be prevented, by the plurality of safety rods 113, from tilting due to its own weight, and may stably maintain the open state.

The safety rod 113, which has one end rotatably connected to the main body 111 and another end supported by the door 112, may have the shape of an elongated rod.

The safety rod 113 may be arranged between the main body 111 and the door 112, to support the door 112, allowing the door 112 to maintain the open state without closing.

In a state in which the door 112 is open, one end of the safety rod 113 may be rotatably connected to the main body 111, and another end may be supported through contact by the rod support part 1123 of the door 112. Accordingly, the door 112 may stably maintain the open state.

Referring to FIG. 6, the safety cover 120, which is arranged in the internal space to cover the circuit board unit 130, may include a main cover 121 and a sub-cover 122.

The safety cover 120 may be arranged inside the main body 111 and may be an area that is exposed when the door is opened. Accordingly, the circuit board arranged on the main plate MP may be protected by the safety cover 120 without being exposed to the outside, even when the door is open.

The safety cover 120 may include a material having insulating properties. For example, the safety cover 120 may include a thermoplastic plastic such as polyvinyl chloride (PVC) or polycarbonate (PC), a thermosetting plastic such as epoxy resin or melamine resin, or a metal cover whose surface is treated with an insulating coating.

A portion of the circuit board arranged on the main plate MP may be exposed to the outside without being covered by the safety cover 120. The portion of the circuit board that is exposed to the outside may be an area to which various cables, such as a communication cable or a power cable, are connected during the installation of the inverter 100.

In other words, a connection terminal, to which various cables may be connected, may be arranged in the portion of the circuit board that is exposed to the outside. A cable connected to an external source may be coupled to the connection terminal and thus electrically connected to the circuit board.

The main cover 121 may cover the entire circuit board except for the portion that is exposed to the outside. Accordingly, during the installation of the inverter 100, the circuit boards to which worker contact is prohibited may be safely protected by the safety cover 120, and only the circuit boards on which connection terminals are arranged may be exposed, enabling an easy installation process.

The sub-cover 122, which covers a fuse mounted on the circuit board, may be arranged on a surface of the main cover 121. The sub-cover 122 may be coupled to the main cover 121 in a snap-fit manner, to be easily detached from the main cover 121 when fuse replacement is necessary.

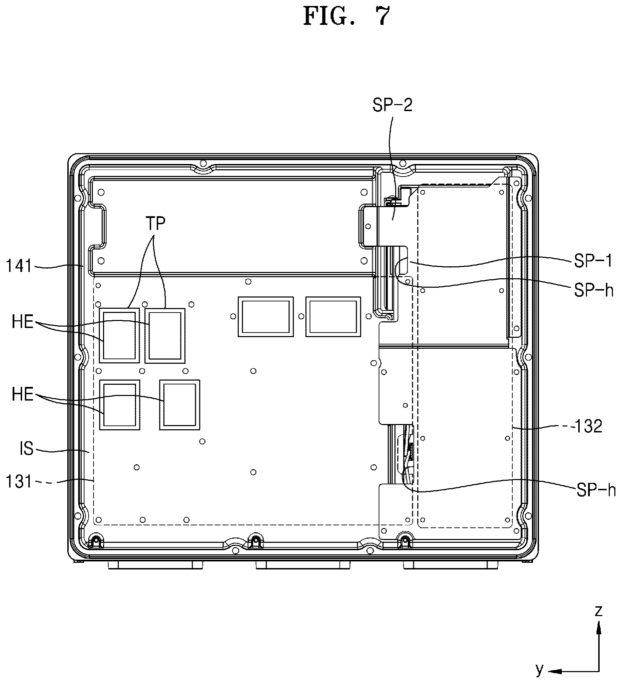

FIG. 7 is a cross-sectional view taken along line I-I' of FIG. 6.

Referring to FIG. 7, the first board 131 and the second board 132 may be arranged in the first body 141. In other words, the first board 131 and the second board 132 may be arranged in the first space S1.

The first board 131 may be arranged on the inner surface IS of the first body 141 and supported by the support block 1411, and the second board 132 may be supported by the sub-plate SP.

The first board 131 and the second board 132 may be arranged side by side.

The second board 132 may be arranged on the sub-plate SP, and the third board 133 may be arranged below the sub-plate SP. In other words, the sub-plate SP may be arranged between the second board 132 and the third board 133, and the second board 132, the sub-plate SP, and the third board 133 may be stacked and arranged in the first direction.

Referring to FIG. 8, the support block 1411, which protrudes into the internal space and on which the first board 131 is arranged, may be provided in the shape of a pillar having a preset cross-sectional area. A plurality of support blocks 1411 may be provided on the inner surface IS of the first body 141, and may be arranged to be spaced apart from each other.

The thermally conductive pad TP may be arranged on an upper surface of the support block 1411. In other words, the support block 1411 may be connected to the inner surface IS of the first body 141, and an opposite side thereof may be connected to the thermally conductive pad TP.

The thermally conductive pad TP is arranged between the support block 1411 and the first board 131, and more specifically, between the support block 1411 and a heating element HE, and may minimize the air gap between the support block 1411 and the circuit board and fill in surface irregularities between the components to maximize thermal conduction efficiency.

The thermally conductive pad TP may have an elastic restoring force. In some embodiments, the thermally conductive pad TP may be manufactured by mixing thermally conductive particles, such as metal oxides or nitrides, with an insulating material, such as silicone or a polymer, and may be formed to have flexibility.

The thermally conductive pad TP may closely adhere to an irregular surface to remove air layers between fine gaps and to maximize heat transfer efficiency.

In other words, the first board 131 may be arranged on the inner surface IS of the first body 141 and supported by the support block 1411. In some embodiments, heat generated from the first board 131 may be transferred to the support block 1411 through the thermally conductive pad TP and then emitted to the outside.

The sub-plate SP, which is arranged in the heat dissipation case 140, and more specifically, on the second body 142, and the second space S2 may be enclosed by the sub-plate SP and the second body 142.

The sub-plate SP may include a cover portion SP-1 and a connection end SP-2.

The cover portion SP-1 may cover an open area of the second body 142 and support the second board 132. As the second body 142, which has the second space S2 therein, is formed to extend in a vertical direction (the z-axis direction in FIG. 7), the cover portion SP-1 that covers the second body 142 may also be formed to extend in the vertical direction.

The connection end SP-2, which extends from the cover portion SP-1 and is supported by the first body 141, may connect the sub-plate SP to the first body 141. The connection end SP-2 may be formed to protrude from one side (the left side in FIG. 7) of the cover portion SP-1.

The side of the connection end SP-2 opposite the cover portion SP-1 may be arranged in the first body 141. In some embodiments, one surface of the connection end SP-2 may be in surface contact with the inner surface IS of the first body 141, and the sub-plate SP may be supported by the inner surface IS and arranged between the first space S1 and the second space S2.

The sub-plate SP may serve as a partition wall that separates the first space S1 and the second space S2.

A plurality of connection ends SP-2 may be arranged along one side of the cover portion SP-1. In some embodiments, a plurality of connection ends SP-2 may be arranged in the lengthwise direction of the cover portion SP-1 and supported by the first body 141.

That is, the sub-plate SP, which is arranged on the second body 142, may support the second board 132 while being supported by the first body 141.

A through-hole SP-h is defined between the cover portion SP-1 and the connection end SP-2, and allows the first space S1 and the second space S2 to communicate with each other.

Connection ends SP-2 may be arranged on opposite sides (the upper and lower sides in FIG. 7) of the through-hole SP-h, respectively. In other words, the through-hole SP-h may be arranged between the connection ends SP-2, which protrude from the cover portion SP-1 and are spaced apart from each other.

The through-hole SP-h may form a movement path for a cable connecting a plurality of circuit boards. In some embodiments, the through-hole SP-h may serve as a passage that allows a cable to be connected and to move from the first space S1 to the second space S2, or from the second space S2 to the first space S1.

A cable may pass through the through-hole SP-h to connect the first board 131 to the third board 133, or to connect the second board 132 to the third board 133.

At least a portion of the first board 131, which is arranged in the first body 141, may be arranged on the sub-plate SP. One side (the right side in FIG. 7) of the first board 131, which is arranged adjacent to the second board 132, may be supported by the sub-plate SP.

The first board 131 may be arranged on the connection end SP-2 and the through-hole SP-h, and in other words, at least a portion of the first board 131 may be arranged to overlap with the third board 133, which is arranged in the second body 142.

The sub-plate SP may include steel. Accordingly, electromagnetic waves generated from the circuit board may be reflected by the sub-plate SP.

In other words, the sub-plate SP may serve to physically shield electromagnetic waves, thereby preventing electromagnetic waves generated from the circuit board arranged in the second body 142 from passing through the sub-plate SP.

The first board 131 may generate a greater amount of heat than other circuit boards.

A plurality of heating elements HE may be arranged in the first board 131. The heating elements HE may be arranged in a lower portion of the circuit board, and may refer to all components that generate heat as current flows therethrough. For example, the heating elements HE may include power devices such as transistors or diodes, resistors, coils, transformers, integrated circuits, and the like.

The support block 1411 may be arranged at a position corresponding to the position of the heating element HE on the first board 131. That is, the heating element HE and the support block 1411 may be arranged to face each other, and the thermally conductive pad TP may be arranged between the heating element HE and the support block 1411.

In other words, the support blocks 1411 may be provided at positions respectively corresponding to the positions of the heating elements HE arranged on the first board 131. Accordingly, the heating elements HE may be arranged on a surface of the first board 131 that is supported by the support block 1411.

Accordingly, heat generated by the heating elements HE of the first board 131 may be quickly discharged to the outside of the heat dissipation case 140 through the thermally conductive pads TP and the support blocks 1411.

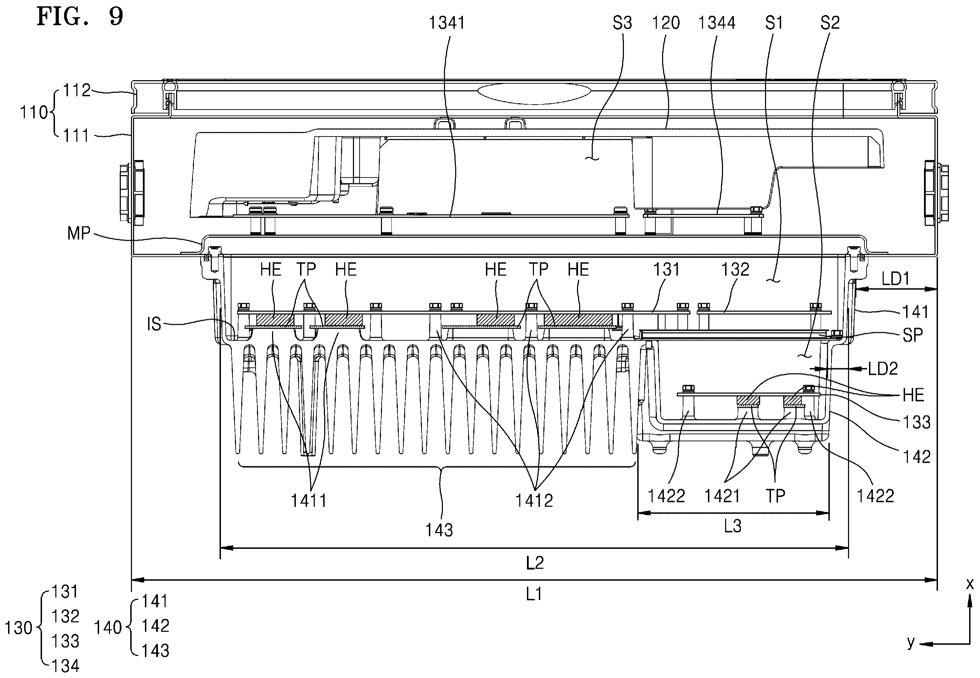

FIG. 8 is a perspective cross-sectional view taken along line II-II' of FIG. 6, and FIG. 9 is a cross-sectional view taken along line II-II' of FIG. 6.

For convenience of descriptions, the heating elements HE are omitted in FIG. 8.

Referring to FIGS. 8 and 9, the first body 141 may have support protrusions 1412 that extend toward the circuit board and support the circuit board. The support protrusion 1412 may connect the circuit board to the heat dissipation case 140, may be formed in a cylindrical shape, and may have formed therein a screw thread to allow a fastening element, such as a screw, to be inserted. In an alternative embodiment, the support protrusion 1412 may have a boss shape.

When the first board 131 is arranged in the heat dissipation case 140, the support blocks 1411 and the support protrusions 1412 may support the first board 131. Here, the support protrusions 1412 and the first board 131 may be fastened together by separate fastening elements, and the position of the first board 131 may be fixed to the heat dissipation case 140.

The first board 131 may be arranged on the inner surface IS of the heat dissipation case 140, and in detail, may be supported by the support blocks 1411, which protrude from the inner surface IS, and may be fixed in position by the support protrusions 1412.

The support blocks 1411 may be arranged on a side opposite the heat dissipation fins 143. In other words, on the surface of the first body 141 opposite the inner surface IS that has the support blocks 1411, a plurality of heat dissipation fins 143 that extend outward may be formed.

Thus, in the heat dissipation case 140, the first board 131, the heating elements HE, the thermally conductive pads TP, the support blocks 1411, and the heat dissipation fins 143 may be arranged sequentially from top to bottom.

Heat generated from the heating elements HE arranged in a lower portion of the first board 131 may be transferred to the support blocks 1411 via the thermally conductive pads TP, and the heat transferred to the support block 1411 may be discharged to the outside through the heat dissipation fins 143, which extend outward.

The second body 142 may have sub-support blocks 1421, which protrude toward the internal space and on which the third board 133 is arranged.

A plurality of sub-support blocks 1421 may be arranged in the second body 142, and may be spaced apart from each other.

Thermally conductive pads TP may be arranged between the sub-support blocks 1421 and the circuit board. Accordingly, heat generated from the circuit board, and more specifically, heat generated from the heating elements HE arranged in a lower portion of the third board 133, may be effectively transferred to the sub-support blocks 1421.

The second body 142 may further have a sub-support protrusion 1422, which extends toward and supports the circuit board. A plurality of sub-support protrusions 1422 may be provided and may be arranged along the circumference of the sub-support block 1421.

Heating elements HE may be arranged in a lower portion of the circuit board that is arranged in the second body 142. Thermally conductive pads TP may be arranged between the heating elements HE and the sub-support blocks 1421, and may contact the circuit board over an area larger than that of the heating elements HE.

In the second body 142 of the heat dissipation case 140, the third board 133, the heating elements HE, the thermally conductive pads TP, and the sub-support blocks 1421 may be arranged sequentially from top to bottom.

The configurations of the sub-support blocks 1421, the sub-support protrusion 1422, and the third board 133 in the second body 142 are substantially the same as those of the support blocks 1411, the support protrusions 1412, and the first board 131 in the first body 141 in terms of operational effects and arrangement relationships, and thus, detailed descriptions thereof will be omitted.

The first board 131 and the second board 132 may be arranged in the first space S1. The first space S1 may be an internal space of the first body 141, or a space enclosed by the inner surface IS of the first body 141, the main plate MP, and the sub-plate SP.

Furthermore, the third board 133 may be arranged in the second space S2. The second space S2 may be an internal space of the second body 142, or a space enclosed by an inner surface of the second body 142 and the sub-plate SP.

The second board 132 may be supported by the sub-plate SP, which is arranged on the second body 142, and the third board 133 may be arranged inside the second body 142.

The fourth board 134 may be arranged in the third space S3. The third space S3 may be a space enclosed by the main case 110 and the main plate MP. The fourth board 134 may be arranged on the main plate MP.

The first board 131 may generate a greater amount of heat than the second board 132 and the third board 133.

The first board 131 may be arranged in the first body 141. In some embodiments, the support blocks 1411 and the thermally conductive pads TP may be arranged on the inner surface IS of the first body 141, and the heat dissipation fins 143 may be provided on the surface opposite the inner surface IS, allowing heat generated from the circuit board to be quickly discharged to the outside.

Thus, the first space S1 of the first body 141 may be a space with a relatively higher heat dissipation efficiency than the second space S2 and the third space S3. Thus, the circuit board that generates the greatest amount of heat may be arranged in the first body 141.

In other words, the first board 131 is the main board of the inverter 100, and a plurality of heating elements HE may be arranged in the first board 131, and the amount of heat generated in the first board 131 may be relatively large compared to other circuit boards. Thus, to prevent overheating inside the inverter 100 and malfunction of the circuit boards, the first board 131 may be arranged in the first body 141, which has the highest heat dissipation efficiency.

The second board 132 and the third board 133, which generate a relatively smaller amount of heat than the first board 131, may be arranged on the sub-plate SP and in the second body 142, respectively.

When the second board 132 and the third board 133 are compared, the third board 133, which is provided as an SMPS board, may generate a greater amount of heat than the second board 132, which is provided as a filter board. In general, an SMPS board performs power conversion and high-speed switching operations, and thus, its power consumption may be greater than that of a filter board, which stabilizes an electrical signal. Thus, a plurality of heating elements HE may also be arranged in the third board 133.

The third board 133 may be arranged in the second body 142, in which the sub-support blocks 1421 and the thermally conductive pads TP are provided, i.e., in the second space S2. Accordingly, heat generated from the third board 133 may be easily discharged to the outside of the inverter 100 through the sub-support blocks 1421 and the thermally conductive pads TP.

That is, in descending order of the amount of heat generated, the first board 131, the third board 133, and the second board 132 may be arranged in the first body 141, the second body 142, and the sub-plate SP, respectively.

Hereinafter, the arrangement of the fourth board 134 will be described.

The fourth board 134 is a circuit board arranged at the outermost part of the inverter 100, and one surface of the fourth board 134 may be supported by the main plate MP, and another surface may be covered by the safety cover 120. When the door 112 is opened, the fourth board 134 may be protected by the safety cover 120 and thus prevented from being exposed to the outside.

The fourth board 134 may include circuit boards connected to the storage device 200.

Referring to FIG. 3, the connection protrusion 201, which forms a coupling between the inverter 100 and the storage device 200, may be arranged at the front of the storage device 200. A cable connected to a battery of the storage device 200 may pass through an inner side of the connection protrusion to be connected to a circuit board of the inverter 100.

The cable may enter the inverter 100 through a coupling groove (not shown), which is formed on a surface of the main case and faces the connection protrusion 201.

Both the connection protrusion 201 and the coupling groove are arranged at the front of the energy storage system 20, and the fourth board 134 may also be arranged at the front of the inverter 100. Accordingly, a cable connected to the storage device 200 may be easily connected to the fourth board 134 without needing to go deep into the internal space.

Referring to FIG. 5, the fourth board 134 may include a plurality of sub-circuit boards. The plurality of sub-circuit boards may include a first sub-board 1341, a second sub-board 1342, a third sub-board 1343, and a fourth sub-board 1344.

The first sub-board 1341 may be provided as a BMS or a BMPS.

Thus, the first sub-board 1341 may be connected to the battery of the storage device 200 to monitor the voltage, current, temperature, and charging/discharging state of the battery. In some embodiments, the first sub-board 1341 may immediately shut off the battery in a state of overvoltage, overcurrent, short circuit, or abnormal temperature, to protect the battery in a dangerous situation.

Referring to FIG. 6, a portion of the fourth board 134 may be exposed to the outside without being covered by the safety cover 120. In some embodiments, the second sub-board 1342, which is arranged on the left side (the left side in FIG. 6) of the main plate MP, may have a connection terminal to which a cable connected to an external source may be connected.

Thus, during the installation and replacement of the inverter 100, only the second sub-board 1342, which has the connection terminal for an external cable, may be exposed, and a worker may easily perform the installation by connecting an external cable to the exposed second sub-board 1342, without needing to remove the entire safety cover 120.

The third sub-board 1343 is arranged on a lower side of the first sub-board 1341, and may be provided as, for example, a relay board that switches a high-power circuit with a low-power signal. Thus, the third sub-board 1343 may be connected to the first sub-board 1341 to receive an electrical signal when an overcurrent or short-circuit condition occurs in the battery, and physically shut off the current circuit.

That is, the fourth board 134 may be arranged on the main plate MP for interaction with the storage device 200 or for connection to an external cable.

Hereinafter, the length of the main body 111 in the second direction is defined as a width L1 of the main body, the length of the first body 141 in the second direction is defined as a width L2 of the first body, and the length of the second body 142 in the second direction is defined as a width L3 of the second body.

The width L1 of the main body may be greater than the width L2 of the first body, and the width L2 of the first body may be greater than the width L3 of the second body. Thus, the inverter 100 may have a shape in which the width decreases toward the bottom (the lower side in FIG. 9).

Due to the differences in width between the components, a step LD1 may be formed between the main body 111 and the first body 141, and a step LD2 may be formed between the first body 141 and the second body 142.

The main plate MP may be supported by the step LD1 between the main body 111 and the first body 141, and thus cover the first body 141. A region of the main plate MP that is arranged in the step LD1 may be in surface contact with the main body 111.

Here, the contacting surfaces of the main body 111 and the main plate MP may be coupled together by a bolt fastening method. However, the present disclosure is not limited thereto, and the main body 111 and the main plate MP may be coupled together by welding or soldering.

Accordingly, the main plate MP may physically shield electromagnetic waves in the internal space, and simultaneously, be in surface contact with the main body 111 to form a movement path for the electromagnetic waves to flow along the surface of the metal.

In some embodiments, the main plate MP may prevent an issue of electromagnetic interference between the first board 131 and the second board 132, which are arranged in the space below the main plate MP, and the fourth board 134, which is arranged on the main plate MP and overlaps with the first board 131 and the second board 132.

One side of the sub-plate SP may be arranged on the inner surface IS of the first body 141, and another side may be arranged in the step LD2 between the first body 141 and the second body 142.

The sub-plate SP may be arranged between the first space S1 and the second space S2 to physically separate the two spaces, and may block electromagnetic waves generated from the third board 133 inside the second space S2.

The sub-plate SP may also be supported by and in surface contact with the first body 141 and the step LD2, and by reflecting electromagnetic waves emitted from the circuit boards, the sub-plate SP may prevent electromagnetic waves generated from the third board 133 from affecting other circuit boards, or prevent electromagnetic waves generated from other circuit boards from affecting the third board 133.

In the inverter 100 according to an embodiment of the present disclosure, the internal space defined by the assembly of the main case 110 and the heat dissipation case 140 is partitioned into three spaces by arranging the main plate MP and the sub-plate SP therein, and the space utilization inside the inverter 100 is maximized by arranging circuit boards in the respective spaces.

Furthermore, because electromagnetic waves are double-shielded by the main plate MP and the sub-plate SP, interference between the circuit boards may be prevented, and electromagnetic waves may be prevented from being emitted to the outside of the inverter 100.

Furthermore, by arranging the board that generates a large amount of heat at a position with high heat dissipation efficiency, heat dissipation performance may be improved while a limited space is effectively utilized.

Although an embodiment of the present disclosure has been described above, the spirit of the present disclosure is not limited to the embodiment presented in the present specification, and those skilled in the art who understand the spirit of the present disclosure may easily suggest other embodiments by adding, modifying, or removing components within the same scope of the spirit, but these embodiments will also fall within the scope of the spirit of the present disclosure.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the spirit and scope as defined by the following claims.

## Claims

1. An inverter comprising:
a main case;
a heat dissipation case that covers one side of the main case and has a plurality of heat dissipation fins;
a main plate arranged in an internal space defined by an assembly of the main case and the heat dissipation case; and
a circuit board unit configured to mutually convert between direct current power and alternating current power and having a plurality of circuit boards,
wherein some of the plurality of circuit boards are arranged below the main plate, and others of the plurality of circuit boards are arranged on the main plate.

2. The inverter of claim 1, wherein the heat dissipation case comprises:
a first body connected to the main case, wherein the plurality of circuit boards are arranged in a first space inside the first body, and the plurality of heat dissipation fins are arranged outside the first body; and
a second body arranged adjacent to the plurality of heat dissipation fins and having a second space recessed downward from the first body.

3. The inverter of claim 2, further comprising a sub-plate that covers an upper portion of the second body.

4. The inverter of claim 3, wherein the sub-plate comprises a cover portion that covers an open area of the second body, and a connection end extending from the cover portion and supported by the first body.

5. The inverter of claim 4, wherein the first space and the second space communicate with each other through a through-hole defined between the cover portion and the connection end.

6. The inverter of claim 2, wherein the circuit board unit comprises:
a first board arranged in the first body;
a second board supported by a sub-plate arranged on the second body; and
a third board arranged inside the second body.

7. The inverter of claim 6, wherein the first board generates a greater amount of heat than the second board and the third board.

8. The inverter of claim 6, wherein the first board and the second board are arranged in a space below the main plate.

9. The inverter of claim 6, wherein a fourth board that overlaps with the first board and the second board is arranged on the main plate.

10. The inverter of claim 1, wherein the main plate comprises a connection hole that communicates with an internal space of the heat dissipation case.

11. An energy storage system comprising:
an inverter; and
a storage device,
wherein the inverter comprises:
a main case;
a heat dissipation case that covers one side of the main case and has a plurality of heat dissipation fins;
a main plate arranged in an internal space defined by an assembly of the main case and the heat dissipation case; and
a circuit board unit configured to mutually convert between direct current power and alternating current power and having a plurality of circuit boards, and
some of the plurality of circuit boards are arranged below the main plate,
others of the plurality of circuit boards are arranged on the main plate, and
the inverter and the storage device are electrically connected to each other.

12. The energy storage system of claim 11, wherein the heat dissipation case comprises:
a first body connected to the main case, wherein the plurality of circuit boards are arranged in a first space inside the first body, and the plurality of heat dissipation fins are arranged outside the first body; and
a second body arranged adjacent to the plurality of heat dissipation fins and having a second space recessed downward from the first body.

13. The energy storage system of claim 12, further comprising a sub-plate that covers an upper portion of the second body.

14. The energy storage system of claim 13, wherein the circuit board unit comprises:
a first board arranged in the first body;
a second board supported by a sub-plate arranged on the second body; and
a third board arranged inside the second body.

15. The energy storage system of claim 11, wherein the main plate comprises a connection hole that communicates with an internal space of the heat dissipation case.
